# EUROPEAN PATENT APPLICATION

(11) **EP 2 390 240 A1**
(43) Date of publication of application: **30.11.2011**
(21) Application number: 10733531.7
(22) Date of filing: 21.01.2010
(51) Int. Cl.: C03C 17/04, H01L 51/50, H05B 33/02

(54) **METHOD FOR PRODUCING ELECTRONIC DEVICE SUBSTRATE, METHOD FOR MANUFACTURING ELECTRONIC DEVICE, ELECTRONIC DEVICE SUBSTRATE, AND ELECTRONIC DEVICE**

(30) Priority: 26.01.2009 JP 2009014796
(71) Applicant: Asahi Glass Company, Limited, Chiyoda-ku Tokyo 100-8405 (JP)
(72) Inventor: NAKAMURA, Nobuhiro, Tokyo 100-8405 (JP); YAMADA, Kenji, Tokyo 100-8405 (JP); MATSUMOTO, Syuji, Tokyo 100-8405 (JP)
(74) Representative: Müller-Boré & Partner Patentanwälte
(86) International application number: PCT/JP2010/050730
(87) International publication number: WO 2010/084924

(57) **Abstract**

A method for producing a substrate for an electronic device, that can improve light extraction efficiency, can easily produces and has high liability is provided. The method includes: a step of heat-melting a glass raw material or a glass to produce a molten glass; a forming step of continuously feeding the molten glass to a bath surface of a molten metal bathtub accommodating a molten metal to form a continuous glass ribbon 6; a step of feeding a glass powder M having a desired composition on the continuous glass ribbon 6 and melting or sintering the glass powder M to form a scattering layer; a step of gradually cooling the scattering layer-attached continuous glass ribbon; and a step of cutting the scattering layer-attached continuous glass ribbon gradually cooled to obtain a scattering layer-attached glass substrate.

## Description

### TECHNICAL FIELD

The present invention relates to a method for producing a substrate for an electronic device, a method for producing an electronic device, a substrate for an electronic device and an electronic device, and particularly relates to an improved technology of light extraction structure of an optical device such as organic LED (Organic Light Emitting Diode).

### BACKGROUND ART

Organic LED element is that an organic layer is sandwiched between electrodes, voltage is applied between the electrodes to inject holes and electrons, those are recombined in the organic layer, and light generated in the course that emitted molecules reach a ground state from an excited state is extracted, and is used in display, backlight and illumination applications.

Refractive index of the organic layer is about 1.8 to 2.1 at a wavelength of 430 nm. On the other hand, for example, the refractive index in the case of using ITO (Indium Tin Oxide) as a translucent electrode layer is generally about 1.9 to 2.1, although varying depending on ITO film-formation conditions and the composition (Sn-In ratio). Thus, the refractive index of the organic layer is close to that of the translucent electrode layer, the emitted layer reaches the interface between the translucent electrode layer and a translucent substrate without total reflection between the organic layer and the translucent electrode layer. The translucent substrate generally uses a glass and a resin substrate. The refractive index of those is about 1.5 to 1.6, and is lower than the refractive index of the organic layer or the translucent electrode layer. Considering from Snell's law, light attempted to enter a glass substrate at a small angle thereto is reflected in a direction of the organic layer by the total reflection, is again reflected by a reflective electrode, and reaches the interface of the glass substrate. In this case, because the incident angle to the glass substrate is unchanged, the reflection is repeated in the organic layer and the translucent electrode layer, and the light cannot be extracted to the outside from the glass substrate. At a rough estimate, about 60% of the emitted light cannot be extracted in this mode (organic layer/translucent electrode layer propagating mode). The same phenomenon occurs in the interface between the substrate and the atmosphere, and about 20% of the emitted light propagates inside the glass by this phenomenon, and cannot be extracted (substrate propagating mode). Therefore, it is the current trend that the amount of light extracted to the outside of the organic LED element is less than 20% of the emitted light.

There is a reference disclosing that a scattering layer is provided on a substrate to improve light extraction efficiency (Patent Document 1). Incidentally, Patent Document 1 discloses that an additional layer (scattering layer) is formed on a translucent substrate by spraying or the like.

### BACKGROUND ART DOCUMENT

### Patent Documents

Patent Document 1: JP-A-2005-63704

### SUMMARY OF THE INVENTION

### PROBLEMS THAT THE INVENTION IS TO SOLVE

However, Patent Document 1 does not describe or suggest to efficiently form a scattering layer.

The present invention has been made in view of the above circumstances, and has an object to provide a method for producing a substrate for an electronic device, that can improve light extraction efficiency, can easily produces and has high liability.

### MEANS FOR SOLVING THE PROBLEMS

The present invention is characterized by including a step of providing a glass substrate; a step of forming a glass powder having a desired composition; and a step of feeding the glass powder on the glass substrate and forming a scattering layer by heat
According to this constitution, the glass powder having a desired composition is formed, and the glass powder is formed into a scattering layer by heat on the glass substrate. This constitution makes it possible to easily form a glass layer having a desired refractive index with good controllability.

The present invention is the method for producing a scattering layer-attached substrate for an electron device, wherein the step of forming the scattering layer further includes a step of firing the glass powder fed on the glass substrate.
According to this constitution, the scattering layer comprising a glass layer having desired characteristics can be formed by feeding the glass powder to the glass substrate and then applying heat for melting the glass powder and forming the glass layer.

The present invention is the method for producing a scattering layer-attached substrate for an electron device, the method including: a step of heat-melting a glass raw material or a glass to produce a molten glass; a forming step of continuously feeding the molten glass to a bath surface of a molten metal bath accommodating a molten metal to form a continuous glass ribbon; a step of feeding a glass powder having a desired composition on the continuous glass ribbon and melting or sintering the glass powder to form a scattering layer; a step of gradually cooling the scattering layer-attached continuous glass ribbon; and a step of cutting the scattering layer-attached continuous glass ribbon gradually cooled to obtain a scattering layer-attached glass substrate.
According to this constitution, the glass powder is melted or sintered on the glass ribbon by utilizing the heat in the gradually-cooling step in the step of forming the glass ribbon, thereby forming the scattering layer. That is, a temperature rising step is not newly added, and the temperature of the glass ribbon at a position in the course of conveying and gradually cooling the glass ribbon is utilized as the heat for melting the glass powder on the glass ribbon and forming the scattering layer. For this reason, the time required for the production can greatly be shortened. Furthermore, because newly temperature rising step and temperature lowering step are unnecessary, thermal history (thermal change) as a glass substrate can be decreased, and deterioration by the thermal change can be prevented.

The present invention is the method for producing a scattering layer-attached substrate for an electronic device, wherein the step of forming the scattering layer includes a step of forming a scattering layer comprising a base material having a first refractive index and a plurality of scattering materials which has a second refractive index different from that of the base material and are dispersed in the base material, in which a distribution of the scattering materials in the scattering layer decreases from the inside of the scattering layer toward the outermost surface thereof.
According to this constitution, the surface is flat, and a uniform film can be formed in the case of forming an electrode on an upper layer, thereby forming a device. Therefore, in the case of forming an optical device having an organic layer sandwiched between two electrodes, such as an organic LED element, the distance between the electrodes can be made uniform, and deterioration by concentration of electric field can be prevented. This is particularly effective in the case of a self light-emitting device.

The present invention also includes the method for producing a scattering layer-attached substrate for an electronic device, wherein the feeding step is a step of directly spraying the glass powder on the substrate by electrostatic powder coating.
According to this constitution, the glass powder can uniformly and easily be fed.

The present invention also includes the method for producing a scattering layer-attached substrate for an electronic device, wherein the feeding step is a step of dispersing the glass powder in a liquid and spraying the liquid by a spraying method.
According to this constitution, the glass powder can uniformly and easily be fed.

The present invention also includes the method for producing a scattering layer-attached substrate for an electronic device, wherein the feeding step is a step of feeding the glass powder on the glass substrate by a thermal spraying method while melting the glass powder.
According to this constitution, even in the case of mixing plural kinds of glass powders, the glass powders can be melted to homogenize, and the molten glass can then be fed.

The present invention also includes the method for producing a scattering layer-attached substrate for an electronic device, wherein the step of forming a glass powder includes: a step of preparing and melting raw materials of the base material having a first refractive index to form a raw glass; and a step of grinding the raw glass so as to have a desired particle diameter and additionally mixing a plurality of scattering materials having a second refractive index different from that of the base material.
According to this constitution, the glass powder having desired scattering materials dispersed therein can be obtained by forming a glass with the desired raw materials of the base material, grinding the glass and then mixing the glass with the scattering materials. The glass powder is fed on a glass substrate or a glass ribbon, thereby a scattering layer comprising the scattering materials and a glass layer having the desired composition can be formed.

The present invention also includes the method for producing a scattering layer-attached substrate for an electronic device, wherein the step of forming a scattering layer includes a step of forming a hemispherical scattering surface on the glass substrate.
According to this constitution, a desired scattering surface can be obtained by controlling the feed amount of the glass powder so as to form a hemispherical shape on the glass substrate by surface tension.

The method for producing an organic LED element of the present invention includes a method for producing a substrate for an electronic device described in the method for producing a scattering layer-attached substrate for an electronic device, and includes a step of forming a layer having light-emitting function on the first electrode, and a step of forming a second electrode on the layer having light-emitting function.
According to this constitution, a film having flat and uniform surface can be formed, the distance between electrodes can be made uniform, deterioration by concentration of electric field can be prevented, and light extraction efficiency is improved by the presence of the scattering layer, thereby attempting the improvement in reliability.

The present invention includes a substrate for an electronic device, comprising a glass substrate and a plurality of glass-scattered regions formed in an island form on the glass substrate.

The present invention also includes the substrate for an electronic device, wherein the plurality of glass-scattered regions formed in an island form is formed on the glass substrate through a glass layer containing scattering materials.

A method for producing a conductive film-attached substrate for an electronic device of the present invention comprises a step of forming a conductive film on the scattering layer of the substrate for an electronic device.

A self light-emitting electronic element of the present invention comprises the conductive film-attached substrate for an electronic device, and sequentially formed on the conductive layer of the substrate for an electronic device, a layer having light-emitting function and a second conductive electrode.

An organic LED element of the present invention is that the layer having light-emitting function is an organic layer.

### ADVANTAGE OF THE INVENTION

According to the above constitutions, the glass powder having a desired composition is fed on the glass substrate and a scattering layer is formed thereon by heat. Therefore, the refractive index can be controlled with high precision, and the scattering layer having a desired refractive index can be extremely easily obtained.

### BRIEF DESCRIPTION OF DRAWINGS

Fig. 1 is a flow chart showing the method for producing an electronic device of an embodiment 1 of the present invention.
Fig. 2 is a cross-sectional schematic view showing a part of production facilities of the scattering layer-attached substrate for an electronic device of the embodiment I of the present invention.
Fig. 3 is a cross-sectional schematic view showing the scattering layer-attached substrate for an electronic device, formed using a method of the embodiment 1 of the present invention.
Fig. 4 is a cross-sectional schematic view showing an electronic device formed using a method of the embodiment 1 of the present invention.
Fig. 5 is an enlarged view of a major part showing a scattering layer forming apparatus of production facilities of a scattering layer-attached substrate for an electronic device of an embodiment 2 of the present invention.
Fig. 6 is an explanatory view showing a method for producing a scattering layer-attached substrate for an electronic device of the examples of the present invention.
Figs. 7 are schematic views showing a scattering layer-attached substrate for an electronic device of the examples of the present invention, in which (a) is a top view and (b) is a cross-sectional view.

### MODE FOR CARRYING OUT THE INVENTION

The embodiment of the present invention is described in detail below by reference to the drawings.

### (Embodiment 1)

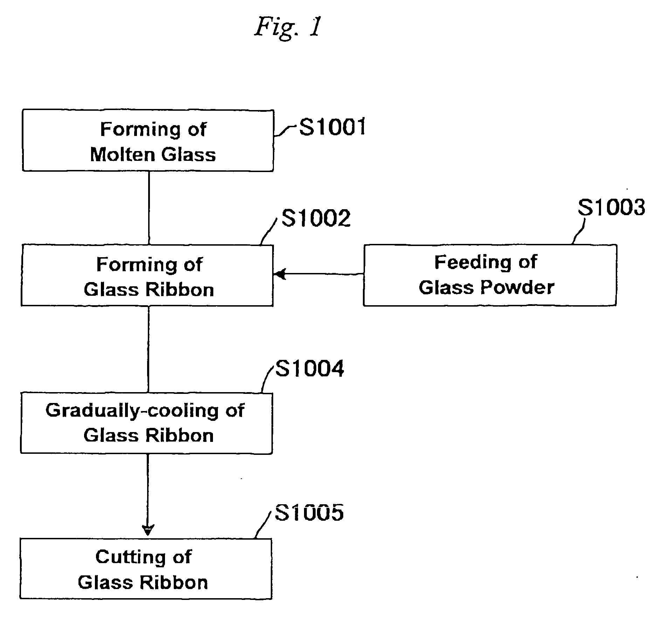

A method for producing a substrate for an electronic device of the present invention comprises a step of heat-melting a glass raw material or a glass to produce a molten glass (step S 1001), a forming step of continuously feeding the molten glass to a bath surface of a molten metal bathtub (molten metal tank) accommodating the molten metal and forming a continuous glass ribbon (step S1002), a step of feeding a glass powder having a desired composition on the continuous glass ribbon and forming a scattering layer by the melting of the glass powder (step S1003), a step of gradually cooling the scattering layer-attached continuous glass ribbon (step S1004), and a step of cutting the gradually cooled scattering layer-attached continuous glass ribbon to form a scattering layer-attached glass substrate (step S1005), as shown in the flow chart of Fig. 1.

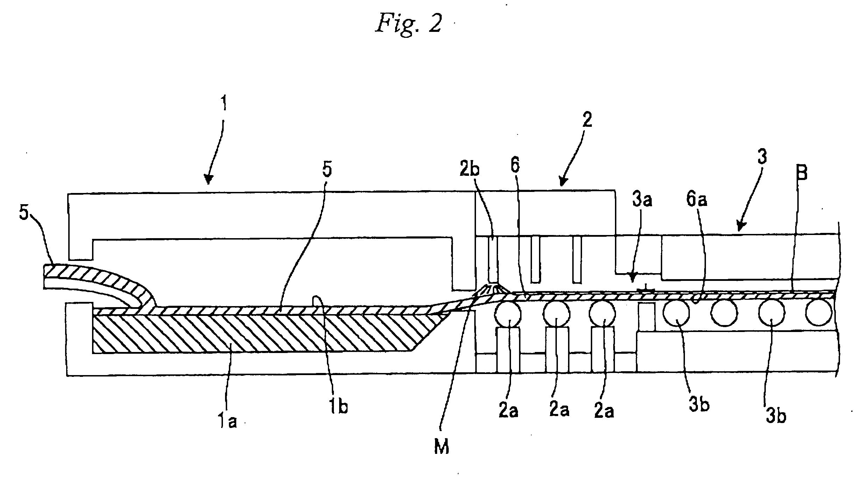

Fig. 2 is a cross-sectional schematic view showing a part of production facilities used in the method for producing a substrate for an electronic device of the present embodiment.
The production facilities of a sheet glass shown in Fig. 2 is arranged in a latter stage of a melting and refining tank (not shown) which prepares and refines a molten glass, and is nearly constituted of a molten metal tank 1 accommodating a molten metal 1a, a conveying chamber 2 arranged in a latter stage of the molten metal tank 1, and a gradually-cooling furnace 3 arranged in a latter stage of the conveying chamber 2. A spray nozzle 2b is arranged as a scattering layer forming apparatus according to the present invention in the vicinity of the inlet of the conveying chamber 2. The latter stage of the gradually-cooling furnace 3 is equipped with a defect detector (not shown) inspecting the surface of the glass ribbon and a cutter (not shown) cutting the cooled glass ribbon.

In the method for producing a scattering layer-attached substrate for an electronic device by a float process, the production facilities shown in Fig. 2 are used. First, a molten glass is continuously fed to a horizontal bath surface of the molten metal tank 1 accommodating a molten metal to form a glass ribbon 6, the glass ribbon 6 is pulled up from the outlet of the molten metal bath and removed outside the molten metal tank. The glass ribbon is formed to have a target thickness by a stretching force pulling up the glass ribbon from the bathtub. While conveying the glass ribbon on a lift-out roll 2a, a suspension formed by dispersing a glass powder for forming a scattering layer in ethanol is fed on the glass ribbon through a spray nozzle 2b by a spraying method, and the glass ribbon is sent to a gradually-cooling furnace 3 and gradually cooled therein while transporting the glass ribbon in the gradually-cooling furnace. The glass ribbon is cut into a given length. Thus, a scattering layer-attached substrate for an electronic device is produced.

The molten metal tank 1 is filled with the molten metal 1a such as metallic tin, and is constituted such that the molten glass 5 is continuously fed on the bath surface 1b of the molten metal 1a from a melting and refining tank (not shown, hereinafter the same).
The spray nozzle 2b for feeding the suspension of the glass powder is arranged in the vicinity of the inlet of the conveying chamber 2 so as to face the lift-out roll 2a, and the suspension of the glass powder is fed on the glass ribbon 6.
The conveying chamber 2 is equipped with the lift-out roll 2a, and the glass ribbon 6 formed in a sheet shape is extracted from the molten metal tank 1 by a traction force of the lift-out roll 2a.
The gradually-cooling furnace 3 is equipped with a lehr roll 3b, and the glass ribbon 6 conveyed from the conveying chamber 2 is conveyed in the gradually-cooling furnace 3 by the lehr roll 3b.

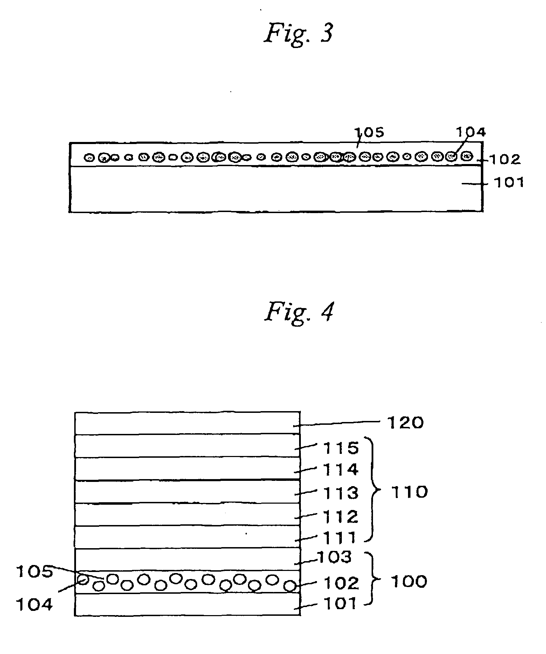

The molten glass 5 melted in the melting and refining furnace is continuously fed on the bath surface 1b of the molten metal 1a in the molten metal tank 1 from the melting and refining furnace, and the molten metal 5 is formed into desired thickness and width, and then pulled out of the inlet of the molten metal tank 1 while stretching by traction force of the lift-out roll 2a, while receiving the feed of the suspension of the glass powder from the spray nozzle 2b. In this case, the molten glass 5 is controlled to a temperature capable of undergoing plastic deformation, thereby the scattering layer-attached glass ribbon 6 is obtained. The scattering layer-attached glass ribbon 6 formed is passed through the conveying chamber 2 to convey into the gradually-cooling furnace 3, and gradually cooled during passing through the inside of the gradually-cooling furnace 3. In this case, the scattering layer (see Figs. 3 and 4; not shown here) is formed on the upper surface of the glass ribbon 6 by the spray nozzle 2b arranged at the inlet of the conveying chamber 2.

The case that the spray nozzle 2b for forming a scattering layer is arranged at the inlet of the conveying chamber 2 is described in this embodiment. However, the spray nozzle 2 may be arranged in the step after the molten metal tank 1, and for example, may be arranged in the gradually-cooling furnace 3. The spray nozzle 2b feeds the suspension of the glass powder to the glass ribbon 6. From the standpoint of the formation at high temperature, it is preferred to arrange the spray nozzle 2b just after the molten metal tank 1 as possible, but it is preferred to arrange the spray nozzle 2b at the inlet of the gradually-cooling furnace 3 at which the glass is in a stabilized state (hereinafter the same in an embodiment 2).

As described above, according to this embodiment, a scattering layer comprising a glass powder M is formed on the upper surface of the glass ribbon 6 becoming a substrate by a spraying method. Therefore, there is no concern that the glass powder M scatters in the inside of the conveying chamber 2, and deterioration of facilities in the conveying chamber 2 can be prevented. Furthermore, according to this embodiment, a scattering layer B can be formed, regardless of the composition of a glass. According to this embodiment, the glass powder M is fed on the glass ribbon 6 in a heated state. The glass powder M adhered to the glass ribbon 6 is melted by the heat of the glass ribbon 6 itself. Therefore, adhesion at the interface between the glass ribbon 6 becoming a glass substrate and a glass powder layer becoming a scattering layer is good. Depending on the surface temperature of the glass ribbon 6, an intermediate layer can be formed at the interface between the glass ribbon 6 becoming a glass substrate and the glass powder layer becoming a scattering layer. The intermediate layer is effective to improve adhesion between the glass substrate and the scattering layer and improve optical properties. For this reason, by controlling the position at which the glass powder is fed to the glass ribbon, that is, the position in the conveying chamber or the gradually-cooling chamber, the surface temperature of the glass ribbon 6 becoming a glass substrate can be controlled.

In this embodiment, the glass powder is melted by directly utilizing the temperature of the glass ribbon 6 at the time of retaining in the conveying chamber 2 and/or the gradually-cooling furnace 3. Therefore, it is not necessary to additionally provide a heating apparatus, and this is economical. Furthermore, in this embodiment, by directly utilizing the temperature of the glass ribbon 6, thermal history (thermal change) of the glass substrate can be reduced, and deterioration by the thermal change can be prevented. In this embodiment, by directly utilizing the temperature of the glass ribbon 6, it is not necessary to again heat for the formation of the scattering layer, and therefore, energy can be reduced. As a result, this embodiment is gentle to the environment and can contribute to CO₂ reduction.
Furthermore, in this embodiment, the spray nozzle 2b for spraying the glass powder M is arranged in the existing conveying chamber 2 and/or the gradually-cooling furnace 3, and the glass powder is melted within the retention time. Therefore, the scattering layer can be formed during the production time of the existing glass. For this reason, in this embodiment, the time required for the production can greatly be shortened.

In the above method, one surface of a sheet glass is formed by a bath surface of molten metal and additionally, a free surface which is other surface is formed by that the molten glass spreads on the molten glass, Therefore, flatness of the sheet glass is extremely high, and the method is suitable for mass production.

In the float process, the high temperature glass ribbon conveyed on the lift-out roll is gradually cooled while controlling a cooling rate in the gradually-cooling furnace of the latter stage. Therefore, breakage due to rapid shrinkage of a glass and decrease in flatness can be prevented.

Scattering layer-attached substrate for an electronic device, formed by the method of the above embodiment, and an organic LED element using the same are described below. Fig. 3 is a cross-sectional view showing the structure of the scattering layer-attached substrate for an electronic device, and Fig. 4 is a cross-sectional view showing the structure of an organic LED element using the same.
Electrode- and scattering layer-attached substrate 100 for an electronic device of the present invention is constituted of a translucent glass electrode 10I, a scattering layer 102 and a translucent electrode (not shown), as shown in Fig. 3.
As shown in Fig. 4, the organic LED element of the present invention is constituted of the electrode- and scattering layer-attached substrate 100 for an electronic device, an organic layer 110, and a reflective electrode 120.

In the production, the electrode- and scattering layer-attached substrate for an electronic device is formed by the method described in detail below, and the organic layer 110 containing a charge injection layer and a light-emitting layer is formed by a vapor deposition method or a coating method, and the reflective electrode is finally formed.

The electrode and scattering layer-attached substrate 100 for an electronic device of the present invention comprises the translucent glass substrate 101, the scattering layer 102 comprising a glass and being formed on the glass substrate, and a translucent electrode 103. The scattering layer 102 comprises a base material 105 having a first refractive index for one wavelength of the transmitted light, and a plurality of scattering materials 104 having a second refractive index different from that of the base material 105 and being dispersed in the base material 105. Distribution of the scattering materials 104 dispersed in the scattering layer 102 decreases from the inside of the scattering layer 102 toward the translucent electrode 103. The scattering materials 104 in this case are air bubbles. Incidentally, the translucent electrode 103 has a third reflective index equal to or lower than that of the first refractive index.

The density ρ₁ of the scattering material 104 in a half thickness (δ/2) of the scattering layer 102 comprising a glass, and the density ρ₂ of the scattering material 104 at the distance x (δ/2<x≤δ) from the surface of the scattering layer 102 at the side facing the translucent electrode 103 (that is, the surface at the substrate side) is satisfied with ρ₁≥ρ₂.

Furthermore, the density ρ₂ of the scattering material 104 at the distance x (x≤0.2 µm)) from the surface at the translucent electrode 103 side of the scattering layer 102 comprising a glass is satisfied with ρ₁≥ρ₂ to the density ρ₁ of the scattering material 104 at the distance x=2 µm. Thus, it is desired that the density ρ₂ is smaller in the vicinity of the surface. This fact is clear from that as a result of the measurement in the case that the surface temperatures of the glass ribbon are 570°C and 580°C, the same results could be obtained even though slightly changing the surface temperature.

The scattering layer 102 formed in the regions in which the surface temperature of the glass ribbon 6 is 570°C and 580°C were cut, and its cross-section was polished, and its SEM photograph of 10,000 magnifications was taken. The relationship between the number of gas bubbles and the distance of the gas bubbles from the surface of the glass scattering layer was examined from the photograph. The length in the longitudinal direction of the SEM photograph was 12.5 µm. Lines were drawn with 0.25 µm intervals from the surface of the scattering layer on the SEM photograph, and the number of bubbles that could be confirmed in the frame of 0.25 µm × 12.5 µm was counted. Bubbles present bridging plural frames were counted as being present in the lower frame. As a result, it was seen that the density ρ is further decreased in the region near the surface of the translucent electrode side.

It is desired that the density ρ₂ of the scattering material at the distance x (x≤0.2 µm) from the surface at the translucent electrode side of the scattering layer comprising a glass is satisfied with ρ₁>ρ₂ to the density ρ₁ of the scattering material at the distance x=5 µm. The consideration on the above scattering material will become apparent by referring to PCT/JP2008/063319 which is the application by the present applicant.

According to this constitution, the scattering material comprising gas bubbles, precipitated crystals and a material having a composition different from the base material is present in the inside of the scattering layer in an amount larger than the surface layer of the scattering layer comprising the glass layer and just below thereof. Therefore, the surface of the scattering layer is flat and smooth. For this reason, the thickness of the translucent electrode formed on the flat scattering layer can be made uniform, and its surface becomes flat and smooth. Similarly, the thicknesses of the organic layer formed on the flat and smooth translucent electrode, and the reflective electrode formed on the organic layer can be made uniform, and the surfaces of those become flat and smooth. As a result, large voltage is not locally applied to the layer having luminescent function, and long life can be achieved.

In the case of forming a display device constituted of fine pixels like a high resolution display, it is necessary to form fine pixel patterns. Unevenness on the surface causes deviation in the position of pixel and the size, and additionally had the problem that the organic LED element is short-circuited by the unevenness. However, fine patterns can be formed with good precision.

The surface roughness Ra on the surface of the scattering layer is preferably 30 nm or less, and more preferably 10 nm or less. As a result, the translucent electrode can be formed in a small thickness without receiving the influence of an undercoat. Where the surface roughness Ra on the surface of the scattering layer exceeds 30 nm, the coatability of the organic layer formed on the scattering layer may be deteriorated, and short-circuit may occur between the transparent electrode formed on the glass scattering layer and other one electrode. By the short-circuit between the electrodes, the element does not light. However, there is the case that repair becomes possible by applying overcurrent. To make the repair possible, the surface roughness Ra of the glass scattering layer is preferably 10 nm or less, and more preferably 3 nm or less.

It is known that in a certain material system, in the case where the temperature of the glass ribbon 6 when the glass powder M is fed to the glass ribbon 6 is 570°C or higher, the surface roughness can be made 10 nm or less (see Table 1). Although the optimum film-forming conditions vary depending on the material system, by controlling the kind and the size of the scattering material, the scattering material can be suppressed from being present on the outermost surface, and the scattering layer having excellent surface smoothness can be obtained.

**Table 1**

| | Mass% | Mole% |
|---|---|---|
| P₂O₅ | 16.4 | 23.1 |
| B₂O₃ | 4.2 | 12 |
| Li₂O | 1.7 | 11.6 |
| Na₂O | 0 | 0 |
| K₂O | 0 | 0 |
| Bi₂O₃ | 38.7 | 16.6 |
| TiO₂ | 3.5 | 8.7 |
| Nb₂O₅ | 23.4 | 17.6 |
| WO₃ | 12.1 | 10.4 |

After forming the scattering layer on the glass ribbon, firing may again be conducted.
Regarding the size of the scattering material, in the case that gas bubbles are present in the scattering layer, when the size of gas bubbles is increased, buoyancy is increased in the course of the scattering layer formation process such as melting or firing, and the gas bubbles are liable to ascend. When the gas bubbles reach the outermost surface, the gas bubbles burst, and there is a possibility to remarkably decrease surface smoothness. Furthermore, the number of the scattering material in the portion is relatively decreased. As result, the scattering property is decreased in only the portion. Thus, when large air bubbles are aggregated, the aggregate may visually be confirmed as undulation. The proportion of gas bubbles having a diameter of 5 µm or more is desirably 15% or less, more desirably 10% or less, and further desirably 7% or less. Even in the case that the scattering material is other than gas bubbles, the number of the scattering materials in the portion is relatively decreased, and the scattering property is decreased in only the portion. For this reason, the proportion of the scattering materials having the greatest length of 5 µm is desirably 15% or less, more desirably 10% or less, and further desirably 7% or less.

A method for producing a glass powder for forming a scattering layer is described below.

### (Preparation method of glass powder)

A glass powder is provided. The glass powder used here is obtained by grinding a glass formed by controlling a material composition and a scattering material so as to achieve a desired refractive index, into a desired particle diameter.
That is, powder raw materials were prepared and melted so as to have a desired composition, and the molten powder raw material was dry-ground with an alumina-made ball mill for 12 hours to prepare a glass powder having an average particle diameter (d50, particle size of integrated value 50%; unit: µm) of 1 to 3 µm. A glass transition temperature of the glass thus prepared is 483°C, a deformation point thereof is 528°C, and a thermal expansion coefficient thereof is 83×10⁻⁷ (1/°C). The refractive index nF in F-ray (486.13 nm) of the glass is 2.03558, the refractive index nd in d-ray (587.56 nm) is 1.99810, and the refractive index nC in C-ray (656.27 nm) is 1.98344. The refractive index was measured with a refractometer (product of Kalnew Optical Industrial Co., Ltd., trade name: KRP-2). The glass transition point (Tg) and the deformation point (At) were measured with a thermoanalyzer (product of Bruker, trade name: TD5000SA) by a thermal expansion method in a temperature rising rate of 5°C/min.

The glass powder used is desirably that D₁₀ of the particle diameter is 0.2 µm or more and D₉₀ thereof is 5 µm or less. Where D₉₀ of the particle diameter exceeds 5 µm, the value to the film thickness of the scattering layer is increased, and uniformity of the surface is decreased. On the other hand, where D₁₀ of the particle diameter is less than 0.2 µm, the presence ratio of the interface is increased, and there are the problems that crystals are easily precipitated and devitrification easily occurs.

The composition shown in Table 1 is used as a glass composition forming the scattering layer. The composition is not particularly limited so long as the desired scattering properties are obtained and the suspension can be formed. To maximize the extraction efficiency, examples of the composition include a system containing P₂O₅ and at least one component selected from the group consisting of Nb₂O₅, Bi₂O₃, TiO₂ and WO₃, a system containing B₂O₃ and La₂O₃ as the essential components and at least one component selected from the group consisting of Nb₂O₅, ZrO₂, Ta₂O₅ and WO₃, a system containing SiO₂ as the essential component and any one component of Nb₂O₅ and TiO₂, and a system containing Bi₂O₃ as the main component and SiO₂ and/or B₂O₃ as glass forming auxiliaries. In all of glass systems used as the scattering layer in the present invention, As₂O₃, PbO, CdO, ThO₂ and HgO which are the components having the possibility of adversely affecting the environment should not be contained, except for the case of unavoidably containing as impurities originated from raw materials.

In the case that the refractive index may be low, R₂O-RO-BaO-B₂O₃-SiO₂, RO-Al₂O₃-P₂O₅, R₂O-B₂O₃-SiO₂, and the like can be used.
R₂O contains any one of Li₂O, Na₂O and K₂O, RO contains any one of MgO, CaO and SrO.

### (Second embodiment 2)

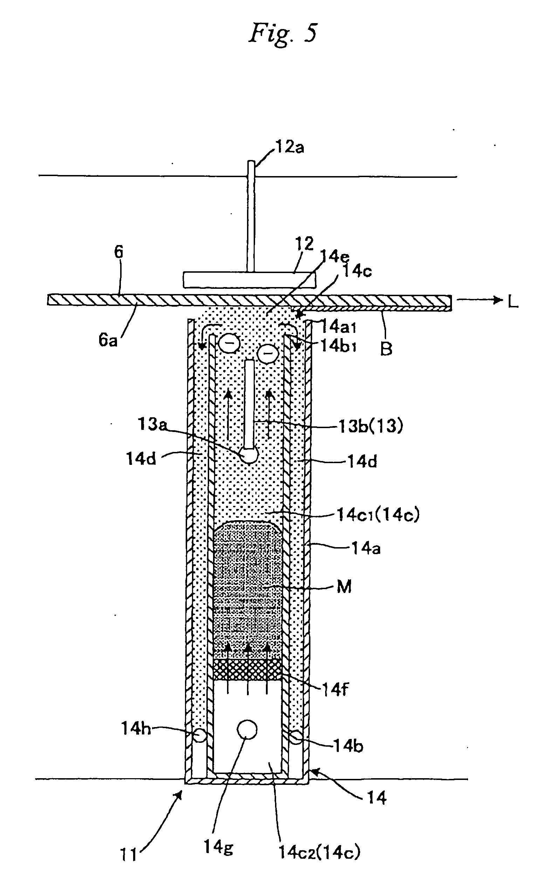

Second embodiment of the present invention is described below.
In the embodiment 1, the glass layer becoming the scattering layer B was formed by spraying the suspension from the spray nozzle 2b at the inlet of the conveying chamber 2 while forming the glass ribbon 6 becoming a substrate. The embodiment 2 is **characterized in that** the scattering layer B is formed by directly spraying the glass powder on the substrate (glass ribbon 6) by electrostatic powder coating, as shown in Fig. 5 which is an enlarged view of the major part of the production apparatus. The same apparatus as the apparatus of the embodiment 1 shown in Fig. 2 is basically used even in this embodiment. However, the apparatus of the embodiment 2 differs from the apparatus of the embodiment 1 in that an electrostatic powder coating apparatus (see Fig. 2) is provided at the back side of the glass ribbon, the scattering layer forming apparatus is provided at the inlet of the gradually-cooling furnace 3, and not a roller, but a grip part (not shown) is provided at given intervals in order to prevent pollution and destruction of the glass layer by rollers. The embodiment 2 uses the glass powder in which D₁₀ of the particle diameter is 0.2 µm or more and D₉₀ thereof is 5 µm or less.

One example of the scattering layer forming apparatus according to the present invention is described below by reference to Fig. 5. The scattering layer forming apparatus is arranged at the lower surface 6a side of the glass ribbon 6. The scattering layer forming apparatus is equipped with a charging apparatus 11 (forming means) which holds the glass powder in a charged state and a fluidized state, and an extraction electrode 12 arranged at the position facing the charging apparatus 11 through the glass ribbon 6.

The extraction electrode 12 is a plate-like electrode formed in a nearly rectangular shape in a planar view. The length in a longitudinal direction of the extraction electrode 12 is set to be the same as the width of the glass ribbon 6 or be longer than the width of the glass ribbon 6. The extraction electrode 12 is connected to a high voltage power unit not shown via a wiring 12a, arranged outside the gradually-cooling furnace 3, or is grounded.

The charging apparatus 11 of the glass powder is constituted of a charging electrode 13, and a charging holding vessel 14 which accommodates the charging electrode 13, holds the glass powder M in a fluidized state, and has an opening 14e at the glass ribbon 6 side.
As shown in Fig. 5, the charging electrode 13 is constituted of an electrode body 13a extending along a width direction of the glass ribbon 6, and a plurality of needle-like electrodes 13b projected toward the upper side (glass ribbon 6 side) from the electrode body 13a. The needle-like electrodes 13b are mutually arranged with an equal interval. The material of the charging electrode 13 preferably comprises a heat-resistant material which does not deform and is not oxidized, at about 700°C. For example, stainless steel alloy, nickel or nickel alloy is preferred. The mutual distance of the needle-like electrodes 13b is that electrodes are arranged every 10 cm which is the width of the glass ribbon 6. The shape of the charging electrode 13 is not essential to be the shape of this embodiment, and the shape is not particularly limited so long as the glass powder M can be charged with good efficiency.
Wiring is connected to one end side of the electrode body 13a, and the charging electrode 13 is connected to a high voltage power unit not shown, arranged outside the gradually-cooling furnace 3 through the wiring.

As shown in Fig. 5, the charging holding vessel 14 is constituted of a vessel body 14a, and a pair of partition wall sections 14b provided inside the vessel body 14a. The inner space of the vessel body 14a is partitioned into three spaces by a pair of the partition wall sections 14b. That is, a charging chamber 14c located between the mutual partition wall sections, and a recovery chamber 14d arranged at both sides of the charging chamber 14c through the partition wall sections 14b are formed in the vessel body 14a. The charging chamber 14c and the recovery chamber 14d are provided such that the recovery chamber 14d, the charging chamber 14c and the recovery chamber 14d are arranged in this order along a moving direction L of the glass ribbon 6. The opening 14e is provided at a position facing the glass ribbon 6 of the vessel body 14a, and the charging electrode 13 faces the lower surface 6a of the glass ribbon 6.

The charging chamber 14c is equipped with a rectifying member 14f having pores in an extent that only gas can passes therethrough. The portion upper than the rectifying member 14f is a charging/fluidizing part 14c1 in which the glass powder M is held in a charged and fluidized state. The portion lower than the rectifying member 14f is a gas introduction part 14c2 for ejecting a gas toward the charging/fluidizing part 14c1 in order to make the glass powder M in a fluidized state. The charging electrode 13 is arranged inside the charging/fluidizing part 14c1. A gas introduction pipe 14g is fitted in the gas introduction part 14c2. A feeding apparatus (not shown) which feeds the glass powder M is fitted inside the charging/fluidizing part 14c1. The feeding apparatus is, for example, a screw conveyer.

The glass powder M fed to the charging/fluidizing part 14c1 is desirably a glass powder which is adhered to the glass ribbon 6 to develop a buffer function, and easily forms a fluidized state at high temperature, is easily charged and does not form coarse particles by aggregation.

In addition to the glass powder, a charging auxiliary may be added. The charging auxiliary is preferably a material which can easily be washed out without causing a chemical reaction with a glass, and which does not corrode facilities inside the gradually-cooling furnace 3 (see Fig. 2). For example, at least one powder selected from the group consisting of sulfates of alkali metals or alkaline earth metals, chlorides of alkali metals or alkaline earth metals, carbonates of alkali metals or alkaline earth metals, oxide ceramics, nitride ceramics, and metal sulfides is preferred, and a salt cake (decahydrate of sodium sulfate) is more preferred.

The particle diameter of the glass powder M used is, for example, that D₁₀ of the particle diameter is 0.2 µm or more and D₉₀ thereof is 5 µm or less. The particle size is not particularly limited so long as the glass powder M can uniformly be adhered to the glass ribbon 6.

The charging/fluidizing part 14c1 and the recovery chamber 14d are opened at the lower surface 6a side by the opening 14e provided in the vessel body 14a. Each recovery chamber 14d is equipped with a gas introduction and discharge piping 14h. The gas introduction and discharge piping 14h can discharge an introduced gas containing the glass powder M ejected from the charging/fluidizing part 14c1 and recovered in the recovery chamber 14d to the outside of the vessel body 14a.

The charging holding vessel 14 is arranged in the vicinity of the inlet of the gradually-cooling furnace 3 at which the atmosphere temperature is about 700°C. Therefore, it is preferred that each member of the vessel body 14a, the partition wall section 14b and the rectifying member 14f is constituted of a material having heat resistance. Furthermore, because the charging electrode 12 connected to a high voltage power unit is accommodated in the charging holding vessel 14, it is preferred that each constituting member of the vessel body 14a, the partition wall section 14b and the rectifying member 14f is constituted of a material having insulating property. Examples of the material satisfying heat resistance and insulating property include quartz glass and various heat-resistant ceramics represented by alumina ceramics.

It is preferred that the charging electrode 13 and the wiring for the charging electrode are insulated to the constituting member of the charging holding vessel 14 and facilities inside the gradually-cooling furnace 3. In the case that the charging electrode 13 and its wiring are not sufficiently insulated, discharge occurs in the portion not insulated, and charging efficiency to the glass powder M is decreased, which is not preferred. In particular, the environment in which the charging holding vessel 14 is arranged is high temperature atmosphere having several hundred °C. Therefore, discharge easily occurs even in the portion slightly insufficiently insulated. As the insulation countermeasure, it is desired that a metal member is not close to the wiring inside the gradually-cooling furnace 3 as possible. It is further desired that the wiring is covered with a heat-resistant and insulating material. A material of a tube (not shown) covering the wiring uses a material satisfying heat resistance and insulating property, similar to the constituting material of the charging holding vessel 14.

The recovery chamber 14d is described in detail below. The recovery chamber 14d is partitioned from the charging chamber 14c by the partition wall section 14b. The upper end 14b1 of the partition wall section 14b is located downstream than the top end 14a1 of the vessel body 14a. By this constitution, in the case that a part of the glass powder M fed from the charging chamber 14c is not adhered to the glass ribbon 6 and is scattered circumferentially, the glass powder M scattered is intercepted by the upper end 14a1 of the vessel body 14a, and can be recovered by the recovery chamber 14d.

The gas introduction and discharge piping 14h for sucking and extracting the atmosphere in the recovery chamber 14d is fitted in the recovery chamber 14d, By this constitution, the glass powder M recovered in the recovery chamber 14d can be discharged to the outside of the charging holding vessel 14 and the gradually-cooling furnace 3. By arranging the recovery chamber 14d having the above constitution at both sides of the charging chamber 14c, the glass powder M can be prevented from scattering inside the gradually-cooling furnace 3, thereby contamination in the inside of the gradually-cooling furnace 3 by the glass powder M can be prevented. The glass powder recovered can be reutilized.

In the case where the distance between the opening 14e of the charging holding vessel 14 and the glass ribbon 6 is too short, there is a concern that the glass ribbon 6 is contacted with the charging holding vessel 14 when the glass ribbon 6 was warped. Furthermore, where the distance between the opening 14e and the glass ribbon 6 is too long, the glass powder M is scattered from the space between the opening 14e and the glass ribbon 6, and may contaminate the inside of the gradually-cooling furnace 3. For this reason, the charging holding vessel 14 is arranged so as to approach the glass ribbon 6 to such an extent that the charging holding vessel 14 is not contacted with the glass ribbon 6. For example, the distance between the opening 14e of the charging preventing vessel 14 and the glass ribbon 6 is set to be about 2 to 5 cm.

A method for forming the scattering layer to the glass ribbon 6 is described below by reference to Fig. 5.
The glass powder M is fed to the charging/fluidizing part 14c1 of the charging holding vessel 14. For example, dry air, nitrogen or the like (hereinafter sometimes referred to as "dry air or the like") is fed to the gas introduction part 14c2 from a gas introduction piping 14g. The dry air or the like may be introduced after heating, so as not to affect the temperature inside the gradually-cooling furnace 3. The dry air or the like fed to the gas introduction part 14c2 is uniformly ejected to the charging/fluidizing part 14c1 from the top entire surface through the rectifying member 14f by passing through the rectifying member 14f. The glass powder is blown up by the ejected dry air or the like, and the glass powder M becomes a fluidized state.

At this time, the glass powder M is, for example, negatively charged by supplying electric power to the charging electrode 13. The charging conditions are, for example, preferably 10 kV or more and 100 µA or more, although depending on the kind of the glass powder M, the thickness of the scattering layer to be formed, and the coating amount per unit time.

The glass powder M charged is derived toward the under surface 6a of the glass ribbon 6 by the needle-like electrode 13b. The glass powder M charged is derived toward the lower surface 6a of the glass ribbon 6 even by the extraction electrode 12. The glass ribbon 6 itself is mostly positively charged. By the above, the glass powder M is uniformly adhered to the lower surface 6a of the glass ribbon 6, and a scattering layer B (102) is formed on the lower surface 6a of the glass ribbon 6 by the heat of the glass ribbon.

The glass powder M which was not charged and was not adhered to the glass ribbon 6 after having been formed in a fluidized state in the charging/fluidizing part 14c1 by the dry air or the like, and the glass powder M which was charged but was not adhered to the glass ribbon 6 are fallen in the recovery chamber 14d and discharged outside the charging holding vessel 14 together with the dry air or the like through the gas introduction and discharge piping 14h. By this, contamination in the gradually-cooling furnace is reduced. The glass powder M extracted outside can be collected by a filter and reutilized.

As described above, according to the embodiment 2, the scattering layer B comprising the glass powder M is formed on the lower surface 6a of the glass ribbon 6 by an electrostatic coating method. Therefore, there is no concern that the glass powder M is scattered into the inside of the gradually-cooling furnace 3, and deterioration of facilities in the gradually-cooling furnace can be prevented. Furthermore, because the scattering layer B is formed by a so-called electrostatic coating method in which the glass powder M negatively charged is adhered to the glass ribbon 6 positively charged, the scattering layer B can be formed, regardless of the composition, and the scattering layer can be formed on an alkali-free glass such as a sheet glass for liquid crystal display.

Furthermore, the charging holding vessel 14 is arranged at the lower surface 6a side of the glass ribbon 6, the extraction electrode 12 is arranged at a position facing the charging holding vessel 14, the glass powder M in a charged state is derived toward the lower surface 6a of the glass ribbon 6 by the extraction electrode 12, and the glass powder M is adhered to the lower surface 6a to form the scattering layer B. As a result, the scattering layer B can uniformly be formed on the entire surface of the lower surface 6a. Because the glass ribbon 6 itself is positively charged, even though the extraction electrode 12 is not present, the glass powder M negatively charged is derived to the glass ribbon side by fluidization of the dry air or the like, and the scattering layer B can be formed. However, the presence of the extraction electrode 12 can form the scattering layer with good efficiency.
Furthermore, because the glass powder M is charged at the lower surface 6a side of the glass ribbon 6, the glass powder M charged can promptly be adhered to the glass ribbon 6, thereby forming the scattering layer B, and the formation efficiency of the scattering layer is improved. As a result, the scattering layer B can be formed over the entire surface of the lower surface 6a.

In this embodiment, the glass powder M negatively charged is adhered to the glass ribbon 6 positively charged. However, depending on the compositions of the glass ribbon 6 and the glass powder M, the charged charges may be reverse, and the glass powder M positively charged may be adhered to the glass ribbon 6 negatively charged.

According to this embodiment, the glass powder not adhered is discharged to the outside of the gradually-cooling furnace 3 by the recovery chamber 14d and the gas introduction and discharge piping 14h. Therefore, there is no concern that the inside of the gradually-cooling furnace 3 is contaminated with the glass powder M, and the glass powder M extracted to the outside can be reutilized.

The step of feeding the glass powder on the glass ribbon may use a method of feeding the glass powder on the glass substrate by a melt-spraying method while melting the glass powder, in addition to the above embodiments 1 and 2.

The firing step of heating at a desired temperature may again be conducted. Furthermore, the step of feeding the glass powder may be conducted two times or more.
Furthermore, after forming the glass substrate, the scattering layer may be formed on the glass substrate. In this case, the glass powder may be fed when the glass substrate has ordinary temperature, and then burned.

The step of feed the glass powder to the glass substrate or to the glass ribbon in the course of the formation may include a first step of feeding a first glass powder on the substrate and a second step of feeding a second glass powder under feeding conditions different from those of the first step. By this, the scattering layer having different composition in a thickness direction can be formed. By forming a multilayered film, scattering property can be improved.

The above first and second steps may be steps of feeding glass powders or glass pastes, having mutually different compositions.

A material fed on the glass substrate may be only a glass powder, but a frit glass paste may be used. Particularly, in the case of feeding glass powders having different compositions by two steps, it is desired to use a frit glass paste.
The formation of the frit glass paste is conducted, for example, as follows.
A glass powder and a vehicle are provided. The vehicle used here means a mixture a resin, a solvent and a surfactant. The glass powder used here is obtained by grinding a glass formed by controlling a material composition and a scattering material so as to obtain a desired refractive index, into a desired particle diameter, and a resin, a solvent and various modifiers are added to the glass powder. Specifically, a resin, a surfactant and the like are introduced in a solvent heated to 50 to 80°C. The resulting mixture is allowed to stand for about 4 to 12 hours, followed by filtering.
The glass powder and the vehicle are mixed with a planetary mixer, and are uniformly dispersed with a three-roll mill. The resulting mixture is kneaded with a kneader for the adjustment of viscosity. Generally, the amount of glass material is 70 to 80 wt%, and the amount of the vehicle is 20 to 30 wt%.

In the present invention, the second step may be a step of feeding a glass powder containing components becoming the scattering material in an amount smaller than that of the first step, in the method for producing the scattering layer-attached substrate for an electronic device.
By this, a scattering layer in which the density of the scattering layer is small at the surface side of the scattering layer can be obtained.

The scattering layer is directly formed on the glass substrate. However, the scattering layer may be formed through a barrier layer such that a silica thin film is formed on the glass substrate by a sputtering method, and the scattering layer is then formed. However, by forming the scattering layer comprising a glass on the glass substrate without through an adhesive or an organic layer, extremely stable and flat surface can be obtained. Additionally, by constituting the scattering layer with only an inorganic material, thermally stable and long-life optical device can be formed.

The technical scope of the present invention is not limited to the above embodiments, and various modifications can be made without departing the spirit and scope of the present invention. For example, in the above embodiment 2, the scattering layer is formed by an electrostatic coating method. However, the present invention is limited to this, and the present invention can use any method so long as the glass powder M can be charged and fluidized toward the lower surface 6a of the glass ribbon 6. For example, an electrostatic spray may be used. Furthermore, because the glass ribbon 6 itself is positively charged, there is a case that the glass material M negatively charged can be derived to the glass ribbon side by the flow of the dry air or the like without the extraction electrode 12. Therefore, an extraction electrode may be omitted.
Examples are described below.

### <Examples>

Powder raw materials were prepared so as to have a glass composition shown in Table 1, melted in an electric furnace at 1,100°C, and cast on a roll to obtain a flake of glass. This glass has a glass transition temperature of 499°C, a deformation point of 545°C, and a thermal expansion coefficient of 74×10⁻⁷ (1/°C) (average value of 100 to 300°C). The glass has a refractive index nF in F-ray (486.13 nm) of 2.0448, a refractive index nd in d-ray (587.56 nm) of 2.0065, and a refractive index nC in C-ray (656.27 nm) of 1.9918. The refractive index was measured with a refractometer (product of Kalnew Optical Industrial Co., Ltd., trade name: KRP-2). The glass transition point (Tg) and the deformation point (At) were measured with a thermoanalyzer (product of Bruker, trade name: TD5000SA) by a thermal expansion method in a temperature rising rate of 5°C/min.

The flake thus obtained was ground with a zirconia-made planetary mill for 2 hours, and then sieved to prepare a powder. In this case, the particle size distribution was that D₅₀ is 0.905 µm, D₁₀ is 0.398 µm, and D₉₀ is 3.024 µm. 2.0 g of the glass powder was dispersed in 100 g of ethanol to prepare a suspension.

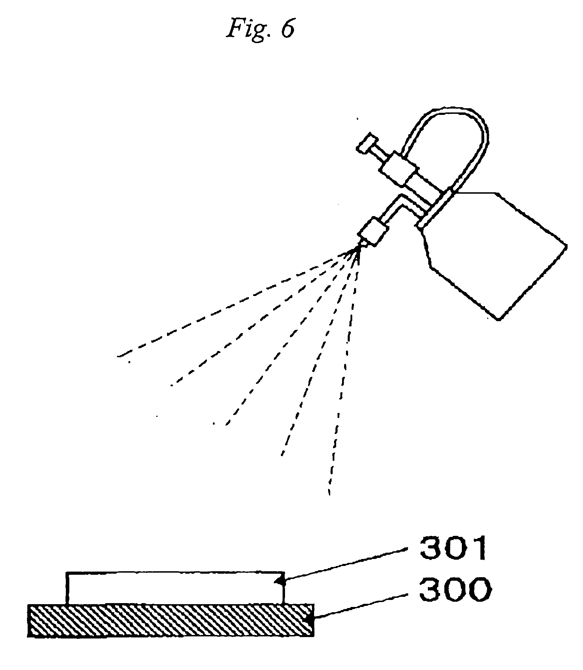

The suspension was sprayed to a substrate 301 heated to 600°C using a sprayer, as shown in Fig. 6. In Fig. 6, the substrate 301 is placed on a ceramic base 300. A soda lime glass having 1 cm square and a thickness of 0.7 mm was used as the substrate, and an infrared ray collecting heating furnace was used for heating the substrate. The infrared ray collecting heating furnace collects infrared ray emitted from an infrared lamp on ceramics absorbing infrared ray.

The ceramics are heated by absorbing infrared ray, and the substrate placed thereon is heated by heat transfer from the ceramics. The sprayer was separated 40 cm from the substrate, and spraying was conducted.
In this case, where the sprayer and the substrate are too close, the glass powder is difficult to hit to the substrate by the wind of the sprayer. Where the sprayer and the substrate are too far, the probability of hitting to the substrate is decreased, resulting in deterioration of the efficiency.

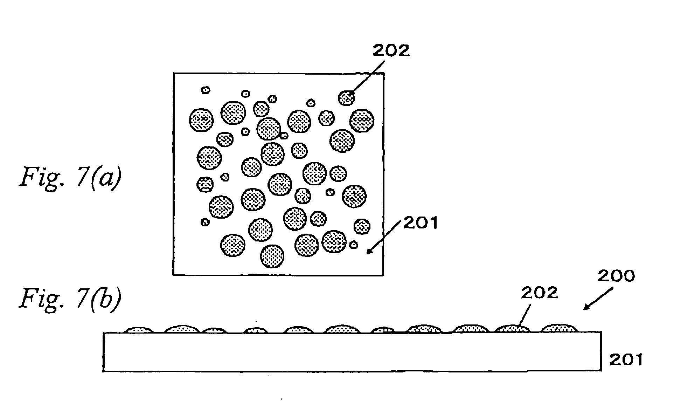

300 mg of the suspension can be injected by one spraying. As a result of repeating this operation 100 times, a sintered film (scattering film) 202 of a glass was formed in an island shape on the substrate 201 as shown in Figs. 7(a) and 7(b). The sintered film bad a hemispherical shape, and had a diameter of 3 to 80 µm. There was a tendency that the shape becomes flat as the diameter is large, and the thickness was about 50 µm at the maximum portion. Furthermore, the coverage of the substrate was about 60%. The sintered film contained air bubbles therein, but a flat surface was formed on the surface thereof. By repeating the operation, a sintered film will be obtained. Thus, the island-shaped sintered film has scattering property at the interface with air. Therefore, a scattering layer-attached substrate 200 for an electronic device, having a scattering layer 202 formed thereon is obtained. Fig. 7(a) is a top view, and Fig. 7(b) is a cross-sectional view.

The substrate 200 for an electronic device thus obtained has a large surface area. Therefore, the substrate is effective to a solar battery and the like, and makes it possible to obtain a solar battery having high power generation efficiency.

This method is that the glass powder is fed on the glass substrate after curing. However, this method can also easily form a film using a sheet glass manufacturing apparatus as described in the embodiments 1 and 2.

This application is based on Japanese Patent Application No. 2009-014796 filed on January 26, 2009, the disclosure of which is incorporated herein by reference in its entity.

The scattering layer-attached substrate for an electronic device of the present invention is effective to high efficiency of optical devices such as various light-emitting devices (such as inorganic EL element or liquid crystal) or light-receiving devices (such as light sensor), without being limited to organic EL elements and solar batteries.

### DESCRIPTION OF THE REFERENCE NUMERALS AND SIGNS

- 1: Molten metal tank
- 1b: Bath surface
- 2a: Lift-out roll
- 2b: Spray nozzle
- 3: Gradually-cooling furnace
- 3a: Inlet of gradually-cooling furnace
- 5: Molten glass
- 6: Glass ribbon
- 6a: Lower surface of glass ribbon
- 11: Charging apparatus (forming means)
- 12: Extraction electrode
- 13: Charging electrode
- 14: Charging holding vessel
- B: Scattering layer
- M: Glass powder

## Claims

1. A method for producing a scattering layer-attached substrate for an electronic device, the method comprising:
a step of providing a glass substrate;
a step of forming a glass powder having a desired composition; and
a step of feeding the glass powder on the glass substrate and forming a scattering layer by heat.

2. The method for producing a scattering layer-attached substrate for an electronic device according to claim 1, wherein the step of forming the scattering layer further comprises a step of firing the glass powder fed on the glass substrate.

3. The method for producing a scattering layer-attached substrate for an electronic device according to claim 1, which includes:
a step of heat-melting a glass raw material or a glass to produce a molten glass;
a forming step of continuously feeding the molten glass to a bath surface of a molten metal bathtub accommodating a molten metal to form a continuous glass ribbon;
a step of feeding a glass powder having a desired composition on the continuous glass ribbon and melting or sintering the glass powder to form a scattering layer;
a step of gradually cooling the scattering layer-attached continuous glass ribbon; and
a step of cutting the scattering layer-attached continuous glass ribbon gradually cooled to obtain a scattering layer-attached glass substrate.

4. The method for producing a scattering layer-attached substrate for an electronic device according to any one of claims 1 to 3, wherein the step of forming the scattering layer is a step of forming a scattering layer comprising a base material having a first refractive index and a plurality of scattering materials which have a second refractive index different from that of the base material and are dispersed in the base material, in which a distribution of the scattering materials in the scattering layer decreases from the inside of the scattering layer toward the outermost surface thereof.

5. The method for producing a scattering layer-attached substrate for an electronic device according to any one of claims 1 to 4, wherein the feeding step is a step of directly spraying the glass powder on the substrate by electrostatic powder coating.

6. The method for producing a scattering layer-attached substrate for an electronic device according to any one of claims 1 to 4, wherein the feeding step is a step of dispersing the glass powder in a liquid and spraying the liquid by a spraying method.

7. The method for producing a scattering layer-attached substrate for an electronic device according to any one of claims 1 to 4, wherein the feeding step is a step of feeding the glass powder on the glass substrate by a thermal spraying method while melting the glass powder.

8. The method for producing a scattering layer-attached substrate for an electronic device according to any one of claims 5 to 7, wherein the feeding step is a step of feeding a glass powder having D₁₀ of a particle diameter of 0.2 µm or more and D₉₀ thereof of 5 µm or less.

9. A substrate for an electronic device, comprising:
a glass substrate, and
a plurality of glass-scattered regions formed in an island form on the glass substrate.

10. The substrate for an electronic device according to claim 9, wherein the plurality of glass-scattered regions formed in an island form is formed on the glass substrate through a glass layer containing scattering materials.

11. A method for producing a substrate for an electronic device provided with a conductive film formed on the scattering layer of the substrate for an electronic device according to claim 9 or 10.

12. A self light-emitting electronic element comprising:
the conductive film-attached substrate for an electronic device, produced according to claim 11, and
a layer having light-emitting function and a second conductive electrode, sequentially formed on the conductive layer of the substrate for an electronic device.

13. The self light-emitting electronic element according to claim 12, which is an organic LED element, wherein the layer having light-emitting function is an organic layer.
